Europäisches Patentamt

(19) European Patent Office

Office européen des brevets

(11) Numéro de publication: **0 129 464**
**B1**

(12) # FASCICULE DE BREVET EUROPEEN

(45) Date de publication du fascicule du brevet:
07.01.87

(51) Int. Cl.⁴: **H 03 H 7/38,** H 01 F 19/04

(21) Numéro de dépôt: **84401170.0**

(22) Date de dépôt: **06.06.84**

(54) Transformateur d'impédance, à large bande, de rapport de transformation voisin de trois, pour radiofréquences.

(30) Priorité: **17.06.83 FR 8310064**

(43) Date de publication de la demande:
**27.12.84 Bulletin 84/52**

(45) Mention de la délivrance du brevet:
**07.01.87 Bulletin 87/2**

(84) Etats contractants désignés:
**DE GB**

(56) Documents cités:
**FR - A - 1 231 183**
**US - A - 3 370 257**
**US - A - 4 222 016**

(73) Titulaire: **THOMSON-CSF, 173, Boulevard Haussmann,**
**F-75379 Paris Cedex 08 (FR)**

(72) Inventeur: **Baer, Jean-Michel, THOMSON-CSF**
**SCPI 173, bld Haussmann, F-75379 Paris Cedex 08 (FR)**

(74) Mandataire: **Courtellemont, Alain et al, THOMSON-CSF**
**SCPI 19, avenue de Messine, F-75008 Paris (FR)**

## Description

La présente invention se rapporte aux transformateurs d'impédance, à large bande, de rapport de transformation d'impédance voisin de trois, travaillant en radiofréquences.

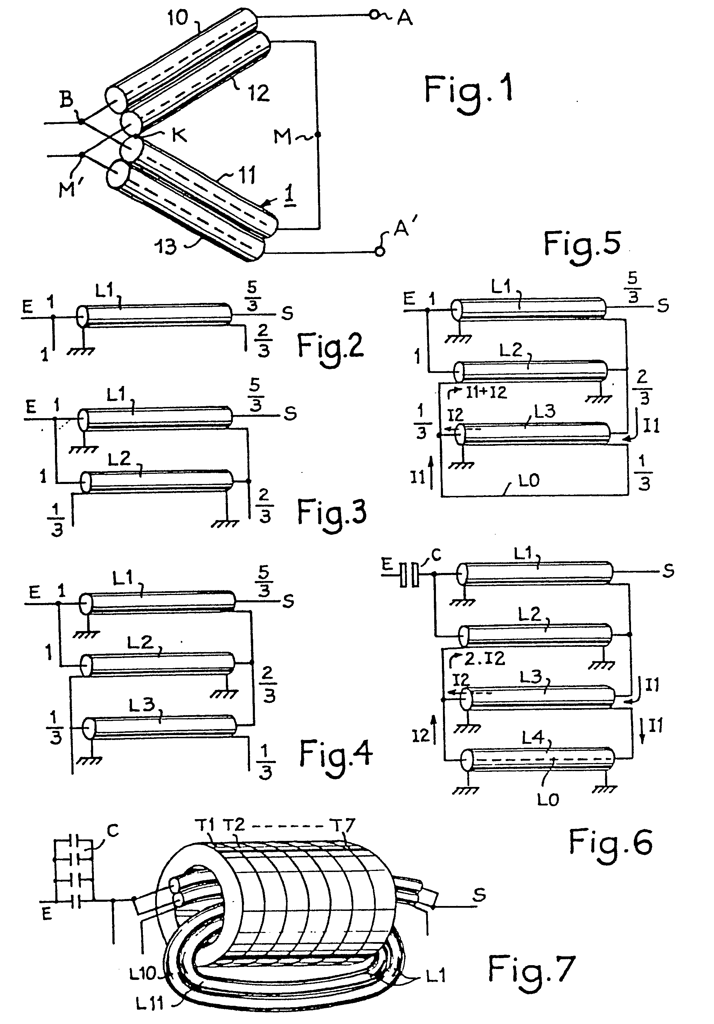

De tels transformateurs sont, en particulier, nécessaires quand trois émetteurs synchronisés, d'impédance de sortie Ro, doivent être couplés à une même antenne d'impédance Ro. En effet un coupleur est alors utilisé, qui comporte trois entrées, sur lesquelles sont branchés les trois émetteurs, et une sortie; mais comme cette sortie présente une impédance $\frac{Ro}{3}$ il est nécessaire d'interposer un transformateur d'impédance, de rapport de transformation d'impédance aussi voisin que possible de 3, entre la sortie du coupleur et l'antenne. Il est connu d'utiliser, comme transformateur d'impédance de rapport de transformation proche de 3, un autotransformateur de rapport de transformation d'impédance égal à 4 formé de quatre tronçons de câble coaxial branchés comme il sera indiqué sur la figure 1 ci-après. Ces transformateurs d'impédance connus, ayant un rapport de transformation assez différent de 3, ne permettent donc pas une bonne adaptation. Pour éviter ceci quand, par exemple, un groupement de trois émetteurs suffirait, il est connu d'utiliser quatre émetteurs; ainsi le transformateur de rapport 4 permet une très bonne adaptation entre la sortie d'impédance $\frac{Ro}{4}$ du coupleur des quatre émetteurs et l'antenne d'impédance Ro. Mais il s'agit là d'une solution onéreuse puisqu'elle conduit à utiliser un émetteur de trop.

La présente invention a pour but d'éviter les inconvénients de l'art connu en proposant un transformateur d'impédance, de rapport de transformation égal à 3 à moins de dix-pour-cent près.

Ceci est obtenu, selon l'invention, grâce à un transformateur d'impédance de rapport $(\frac{5}{3})^2$ c'est-à-dire environ 2,78.

Selon l'invention un transformateur d'impédance pour radiofréquences, réalisé au moyen de câbles coaxiaux, est principalement caractérisé en ce que, de manière à présenter un rapport de transformation voisin de trois, il comporte un premier, un deuxième et un troisième câble coaxial et une liaison, branchés comme suit: le premier câble a la première et la seconde extrémité de son conducteur intérieur respectivement couplées à une borne d'entrée et à une borne de sortie du transformateur et la première extrémité de son conducteur extérieur reliée à une masse; le deuxième câble a la première et la seconde extrémité de son conducteur intérieur respectivement reliées à la première extrémité du conducteur intérieur du premier câble et à la seconde extrémité du conducteur extérieur du premier câble et la seconde extrémité de son conducteur extérieur reliée à la masse; le troisième câble a la première et la seconde extrémité de son conducteur intérieur reliées respectivement à la première extrémité du conducteur extérieur du deuxième câble et à la seconde extrémité du conducteur intérieur du deuxième câble et la première extrémité de son conducteur extérieur reliée à la masse; et la liaison relie entre elles la première extrémité du conducteur intérieur du troisième câble et la seconde extrémité du conducteur extérieur de ce troisième câble.

La présente invention sera mieux comprise et d'autres caractéristiques apparaîtront à l'aide de la description ci-après et des figures s'y rapportant qui représentent:

la figure 1, un transformateur d'impédance selon l'art connu,

les figures 2 à 6, des schémas montrant les étapes successives du raisonnement qui a conduit à l'invention,

la figure 7, la représentation détaillée d'un des éléments selon les figures 5 ou 6.

Sur les différentes figures les éléments correspondants sont désignés par les mêmes symboles.

La figure 1 est un schéma de principe d'un transformateur d'impédance de rapport de transformation égal à 4, dont il a été question plus avant. Ce transformateur peut être défini comme étant un conducteur qui forme deux spires dont les extrémités A et A' constituent les bornes du circuit secondaire, destinées au branchement d'une impédance Ro et dont le point milieu est désigné par la lettre M. Deux bornes, B et M', respectivement branchées au milieu des deux spires constituent les bornes du circuit primaire, destinées au branchement d'une impédance de valeur $\frac{Ro}{4}$. Comme le montre la figure 1, le transformateur est réalisé au moyen de quatre câbles coaxiaux, 10-13, branchés comme suit: les conducteurs intérieurs des câbles 10 à 13 sont respectivement connectés entre les bornes A et B, B et M, M' et M, M' et A' et les conducteurs extérieurs des câbles 10 et 12 d'une part et 11 et 13 d'autre part sont accolés et sont réunis tous les quatre, à l'une de leurs extrémités, par une liaison électrique K. Les inconvénients d'un tel transformateur, dans certains montages où il était jusqu'alors employé, ont été indiqués plus avant.

Pour éviter ces inconvénients en réalisant un transformateur d'impédance de rapport de transformation beaucoup plus proche de 3 que de 4, il est à remarquer que 3 est très proche de $(\frac{5}{3})^2$, c'est-à-dire d'environ 2,78. En procédant par étapes successives et en raisonnant en tensions au lieu de résonner en impédances, un tel transformateur peut être déterminé comme le montrent les figures 2 à 6.

Sur les figures 2 à 5 les chiffres entiers et fractionnaires 1, $\frac{5}{3}$, $\frac{2}{3}$, $\frac{1}{3}$ correspondent, pour une tension U appliquée à l'entrée, E, du coupleur, aux coefficients multiplicatifs de cette tension en divers point du transformateur. C'est ainsi que la tension U appliquée à l'entrée E est représentée par le chiffre 1, tandis que la tension $\frac{5}{3}U$ à obtenir à la sortie S du transformateur, pour avoir le rapport de transformation d'impédance égal à $(\frac{5}{3})^2$, est représentée par le chiffre $\frac{5}{3}$.

La figure 1 représente un câble coaxial L1 dont la première extrémité du conducteur intérieur est reliée à l'entrée E du transformateur et reçoit la tension U; la première extrémité du conducteur extérieur de ce câble coaxial est à la masse: tension nulle. Pour que la sortie S du transformateur, constituée par la seconde extrémité du conducteur intérieur de câble L1, soit à une tension de $\frac{5}{3}$U, il faut que la seconde extrémité du conducteur extérieur du câble L1 soit à une tension de $\frac{2}{3}$U, ce qui donne en effet aux extrémités du câble L1

$$U - 0 = \frac{5}{3}U - \frac{2}{3}U$$

Cette tension de $\frac{2}{3}$U peut être obtenue (figure 3) grâce à un câble coaxial L2 qui reçoit la tension U sur la première extrémité de son conducteur intérieur, la tension $\frac{U}{3}$ sur la première extrémité de son conducteur extérieur et dont la seconde extrémité du conducteur extérieur est à la masse; en effet il vient dans ce cas

$$U - \frac{U}{3} = \frac{2}{3}U - 0$$

Le problème est maintenant d'obtenir la tension $\frac{U}{3}$ à appliquer sur la première extrémité du conducteur extérieur du câble coaxial L2. Pour cela (voir fig. 4) il est possible d'utiliser un troisième câble coaxial, L3, dont la première extrémité du conducteur intérieur est reliée à la première extrémité du conducteur extérieur (tension $\frac{U}{3}$) du câble L2, dont la première extrémité du conducteur extérieur est à la masse (tension nulle), dont la seconde extrémité du conducteur intérieur est reliée à la seconde extrémité du conducteur intérieur du câble L2 (tension $\frac{2}{3}$U) et dont la seconde extrémité du conducteur extérieur est à la tension $\frac{U}{3}$, de manière à avoir l'égalité.

$$\frac{U}{3} - 0 = \frac{2}{3}U - \frac{U}{3}$$

Or, pour avoir $\frac{U}{3}$ sur la première extrémité du conducteur intérieur du câble L3 et sur la seconde extrémité de son conducteur extérieur, il suffit qu'une liaison conductrice forme court-circuit entre ces deux extrémités. Ainsi est réalisé un transformateur d'impédance de rapport $(\frac{5}{3})^2$; la figure 5 est un schéma d'un tel transformateur avec son court-circuit L0 entre la première extrémité du conducteur intérieur du câble L3 et la seconde extrémité du conducteur extérieur de ce même câble.

Il est à noter, dans le schéma de la figura 5, que le courant I1 + I2 qui arrive sur la première extrémité du conducteur extérieur du câble L2 est la somme de deux courants qui ne sont pas en phase: un courant I1 qui passe par le court-circuit L0 et qui est égal au courant qui arrive sur la seconde extrémité du conducteur intérieur du câble L3 et un courant I2 qui provient de la première extrémité du conducteur intérieur du câble L3. Pour mettre en phase ces deux courants et améliorer ainsi le fonctionnement du transformateur, il est possible, comme le montre la figure 6, de remplacer le court-circuit L0 par le conducteur intérieur L0 d'un câble coaxial L4 identique au câble L3 et dont les extrémités du conducteur extérieur sont à la masse; avec le transformateur selon la figure 6, le courant qui arrive sur la première extrémité du conducteur extérieur du câble L2 est la somme de deux courants identiques: I2 + I2.

La figure 6 montre également un condensateur C, branché à l'entrée du transformateur; ce condensateur forme, avec l'inductance répartie des câbles coaxiaux, un filtre passe-haut qui permet d'améliorer la bande passante du transformateur.

La figure 7 montre un exemple de réalisation des câbles coaxiaux L1, L2, L3 des figures 5 et 6. Comme les câbles L2 et L3 sont identiques au câble L1, seul ce dernier câble est représenté. L'exemple décrit correspond à un transformateur sur un accès duquel il est prévu de brancher un dispositif d'émission présentant une impédance de sortie de 16,7 ohms, une bande de fréquences de travail qui va de 20 à 120 MHz et une puissance de sortie de 1000 watts; sur l'autre accès de ce transformateur il est prévu de brancher une antenne d'impédance d'entrée égale à 50 ohms.

La figure 7 montre que le câble coaxial L1 est en fait constitué de deux câbles L10, L11 montés en parallèle. Les deux câbles L10, L11 traversent et entourent sept anneaux succesifs, accolés, T1 à T7. Ces anneaux sont des anneaux de ferrite de type FN 23-1105, commercialisés par la société LTT; ils servent à augmenter l'effet de bobine de choc produit par l'inductance répartie des câbles coaxiaux et, ainsi, à élargir la bande passante du transformateur. Il est à noter que le câble L4 de la figure 6 n'est pas entouré d'anneaux de ferrite, en effet les deux extrémités de son conducteur extérieur étant réunies à la masse, il n'y a pas de courants parasites dans ce conducteur et il n'y a pas besoin de créer une bobine de choc par augmentation, grâce à des ferrites, de l'inductance répartie du câble L4.

Pour ce qui est de l'impédance caractéristique Zc des câbles coaxiaux L1, L2, L3, L4 de la figure 6, elle est déterminée de manière classique en branchant une impédance de 16,7 ohms sur l'entrée E et en calculant l'impédance Zs vue de la sortie S; le résultat est de la forme $Zs = 50$ ohms $+ F \cdot f(Zc) + F^2 \cdot g(Zc) + F^3 \cdot h(Zc) + \ldots$
où F est la fréquence de travail considérée et f(Zc), g(Zc), h(Zc) des fonctions de Zc
Zc est alors choisi pour annuler le terme f(Zc). Dans le cas de l'exemple décrit cela mène à Zc = 30 ohms mais, pour des raisons de commodité, Zc a été pris égal à 25 ohms et réalisé au moyen de deux câbles coaxiaux, d'impédance caractéristique égale à 50 ohms, mis en parallèle.

Il est à noter par ailleurs que, dans l'exemple de réalisation du circuit selon la figure 6, les câbles coaxiaux L1, L2, L3, L4 ont tous une longueur de 20 cm mais que cette longueur n'est pas critique pour le bon fonctionnement du transformateur d'impédance.

Quant au condensateur C de la figure 6, la figure 7 montre qu'il est constitué de quatre condensateurs en parallèle; ces condensateurs sont des condensateurs céramique de type «chipse» (chip dans la littérature anglo-saxonne) de 100 pF chacun.

La présente invention n'est pas limitée à l'exemple décrit et, en particulier, le choix des valeurs d'impédance, pour d'autres réalisation, se fera en fonction des caractéristiques d'entrée et de sortie du transformateur à réaliser.

**Revendications**

1. Transformateur d'impédance, à large bande, pour radiofréquences, réalisé au moyen de câbles coaxiaux, caractérisé en ce que, de manière à présenter un rapport de transformation voisin de trois, il comporte un premier (L1), un deuxième (L2) et un troisième (L3) câble coaxial et une liaison conductrice (LO), branchés comme suit: le premier câble (L1) a la première et la seconde extrémité de son conducteur intérieur respectivement couplées à une borne d'entrée (E) et à une borne de sortie (S) du transformateur et la première extrémité de son conducteur extérieur reliée à une masse; le deuxième câble (L2) a la première et la seconde extrémité de son conducteur intérieur respectivement reliées à la première extrémité du conducteur intérieur du premier câble et à la seconde extrémité du conducteur extérieur du premier câble et la seconde extrémité de son conducteur extérieur reliée à la masse; le troisième câble (L3) a la première et la seconde extrémité de son conducteur intérieur reliées respectivement à la première extrémité du conducteur extérieur du deuxième câble et à la seconde extrémité du conducteur intérieur du deuxième câble et la première extrémité de son conducteur extérieur reliée à la masse; et la liaison (LO) relie entre elles la première extrémité du conducteur intérieur du troisième câble et la seconde extrémité du conducteur extérieur de ce troisième câble.

2. Transformateur selon la revendication 1, caractérisé en ce que la liaison (LO) est un court-circuit.

3. Transformateur selon la revendication 1, caractérisé en ce qu'il comporte un quatrième câble coaxial (L4) dont les extrémités du conducteur extérieur sont à la masse et en ce que la liaison est constituée par le conducteur intérieur (LO) du quatrième câble coaxial.

4. Transformateur selon la revendication 1, caractérisé en ce que la première extrémité du conducteur intérieur du premier câble (L1) est couplée à la borne d'entrée par un condensateur (C).

5. Transformateur selon la revendication 1, caractérisé en ce que les premier, deuxième et troisième câbles coaxiaux sont entourés de circuits magnétiques (T1-T7) destinés à augmenter la valeur de leur inductance apparente.

**Patentansprüche**

1. Breitbandiger Impedanztransformator für Funkfrequenzen, der mittels Koaxialkabeln verwirklicht ist, dadurch gekennzeichnet, dass er in solcher Weise, dass er ein Übertragungsverhältnis in der Nähe von drei aufweist, ein erstes (L1), ein zweites (L2) und ein drittes (L3) Koaxialkabel und eine leitende Verbindung (LO) umfasst, die folgendermassen angeschlossen sind: Bei dem ersten Kabel (L1) sind das erste und das zweite Ende seines Innenleiters mit einem Eingangsanschluss (E) bzw. mit einem Ausgangsanschluss (S) des Transformators verbunden, und das erste Ende seines Aussenleiters ist an Masse angeschlossen; bei dem zweiten Kabel (L2) sind das erste und das zweite Ende des Innenleiters mit dem ersten Ende des Innenleiters des ersten Kabels bzw. mit dem zweiten Ende des Aussenleiters des ersten Kabels verbunden, und das zweite Ende seines Aussenleiters ist mit Masse verbunden; bei dem dritten Kabel (L3) sind das erste und das zweite Ende seines Innenleiters mit dem ersten Ende des Aussenleiters des zweiten Kabels bzw. mit dem zweiten Ende des Innenleiters des zweiten Kabels verbunden, und das erste Ende seines Aussenleiters ist mit Masse verbunden; und die Verbindung (LO) verbindet das erste Ende des Innenleiters des dritten Kabels mit dem zweiten Ende des Aussenleiters dieses dritten Kabels.

2. Transformator nach Anspruch 1, dadurch gekennzeichnet, dass die Verbindung (LO) ein Kurzschluss ist.

3. Transformator nach Anspruch 1, dadurch gekennzeichnet, dass er ein viertes Koaxialkabel (L4) umfasst, bei dem die Enden des Aussenleiters auf Masse liegen, und dass die Verbindung durch den Innenleiter (LO) des vierten Koaxialkabels gebildet ist.

4. Transformator nach Anspruch 1, dadurch gekennzeichnet, dass das erste Ende des Innenleiters des ersten Kabels (L1) an den Eingangsanschluss über einen Kondensator (C) angekoppelt ist.

5. Transformator nach Anspruch 1, dadurch gekennzeichnet, dass das erste, das zweite und das dritte Koaxialkabel von Magnetkreisen (T1-T7) umgeben sind, welche zur Vergrösserung des Wertes ihrer Scheinimpedanz bestimmt sind.

**Claims**

1. Broadband impedance transformer for radiofrequencies, embodied by means of coaxial cables, characterized in that, in a manner to provide a transformation ratio in the neighborhood of three, it comprises a first (L1), a second (L2) and a third (L3) coaxial cable and a conductive connection (LO), connected in the following manner: the first cable (L1) has the first and the second end of its inner conductor coupled to an input terminal (E) and an output terminal (S), respectively, of the transformer and the first end of its outer conductor connected to ground; the second cable (L2) has the first and the second end of its inner conductor connected to the first end of the inner conductor of the first cable and to the second end of the outer conductor of the first cable, respectively, and the second end of its outer conductor connected to ground; the third cable (L3) has the first and the second end of its inner conductor connected to the first end of the outer conductor of the second cable and to the second end of the inner conductor of the second cable, respectively, and the first end of its outer conductor connected to ground; and the connection (LO) connects the first end of the inner conductor of the third cable to the second end of the outer conductor of this third cable.

2. Transformer according to claim 1, characterized in that the connection (LO) is a short-circuit.

3. Transformer according to claim 1, characterized in that it comprises a fourth coaxial cable (L4) having the ends of the outer conductor connected to ground and in that the connection is formed by the inner conductor (LO) of the fourth coaxial cable.

4. Transformer according to claim 1, characterized in that the first end of the inner conductor of the first cable (L1) is coupled to the input terminal through a capacitor (C).

5. Transformer according to claim 1, characterized in that the first, second and third coaxial cables are surrounded by magnetic circuits (T1-T7) susceptible to increase the value of their apparent impedance.

Fig.1

Fig.2

Fig.3

Fig.4

Fig.5

Fig.6

Fig.7